# EUROPÄISCHE PATENTSCHRIFT

(11) **EP 1 118 262 B1**
(45) Veröffentlichungstag und Bekanntmachung des Hinweises auf die Patenterteilung: **17.11.2004**
(21) Anmeldenummer: 99953694.9
(22) Anmeldetag: 02.09.1999
(51) Int. Cl.: H05K 13/08

(54) **VERFAHREN ZUR LAGEERKENNUNG VON IN EINEM BESTÜCKAUTOMATEN AUF EIN SUBSTRAT BESTÜCKTEN BAUELEMENTEN**
METHOD FOR DETECTING THE POSITION OF COMPONENTS PLACED ON A SUBSTRATE BY A PICK-AND-PLACE ROBOT
PROCEDE DE RECONNAISSANCE DE LA POSITION DE COMPOSANTS POSES SUR UN SUBSTRAT PAR UNE MACHINE A POSER DES COMPOSANTS

(30) Priorität: 28.09.1998 DE 19844456
(43) Veröffentlichungstag der Anmeldung: 25.07.2001
(73) Patentinhaber: Siemens Aktiengesellschaft, 80333 München (DE)
(72) Erfinder: SALOMON, Werner, D-85356 Freising (DE); PRITTMANN, Jochen, D-81379 München (DE); GRASMÜLLER, Hans-Horst, D-82291 Mammendorf (DE)
(74) Vertreter: Berg, Peter, Dipl.-Ing.
(86) Internationale Anmeldenummer: PCT/DE1999/002781
(87) Internationale Veröffentlichungsnummer: WO 2000/019800

(56) Entgegenhaltungen:
- EP-A- 0 449 481
- DE-A- 4 121 404

## Beschreibung

Die Erfindung bezieht sich auf ein Verfahren zur Lageerkennung von in einem Bestückautomaten auf ein Substrat bestückten Bauelementen.

Bei der automatischen Bestückung von Substraten (beispielsweise Leiterplatten oder Keramiksubstraten) mit SMD-Bauelementen (SMD = Surface Mounted Device) werden die einzelnen Bauelemente mittels eines Bestückkopfes aus einer Zuführeinrichtung entnommen und dann in einer vorgegebenen Lage auf dem Substrat positioniert.

Aus DE 41 21 404 ist ein Verfahren bekannt, bei dem eine Kontrolle darüber, ob sämtliche Bauelement auch in der vorgegebenen Lage positioniert wurde, nach dem Bestückprozeß außerhalb des Bestückautomaten erfolgt. Zusätzlich wird dort vorgeschlagen, daß anschließend eine Lagekorrektur oder eine Nachbestückung erfolgt. Da der Bestückautomat dabei nicht zur Lageerkennung ausgebildet ist, muß das bestückte Substrat einer separaten Einrichtung zugeführt werden, was im Fertigungsprozeß zu zeitaufwendig ist.

Teilweise wird die Lage der Bauelemente nach dem Bestücken in einem Bestückautomaten außerhalb des Bestückautomaten in separaten Maschinen visuell überprüft. Aus DE 36 18 590 ist es bekannt, Bauelemente auch über bereits bestückte Bauelemente auf das Substrat zu plazieren, die unten liegenden Bauelemente sind einer visuellen Kontrolle dann nicht mehr zugänglich, so daß beispielsweise aufwendige Röntgeninspektionsgeräte benutzt werden müssen.

Aus US 5,003,692 ist ein Verfahren bekannt, bei dem durch eine besonders konstruierte Saugpipette eine dahinter angeordnete Kamera mit Bildauswerteeinheit ein Bild des Substrats vor dem Aufsetzen des Bauelements sowie ein Bild des Substrats mit dem aufgesetzten Bauelement nach dem Aufsetzen aufgenommen wird. Somit wird für jedes Bauelement nach dem Aufsetzen die Position überprüft. Die dafür nötige Konstruktion der Saugpipette ist allerdings sehr aufwendig und die zeitintensive Aufnahme der Position jedes bestückten Bauelementes ist in der Regel nicht erforderlich.

Eine fehlerhafte Lage eines Bauelements nach dem Beenden des Bestückprozesses wird häufig durch eine negative elektrische Funktionsüberprüfung entdeckt. In diesem Fall ist häufig an eine Beseitigung des Fehlers nicht mehr zu denken und das Substrat ist nicht mehr zu gebrauchen.

Es ist daher die Aufgabe, ein einfaches Verfahren zur Lageerkennung von Bauelementen auf einem Substrat anzugeben, wodurch die Bauelemente frühzeitig auf ihre tatsächliche Lage überprüft werden.

Die Aufgabe wird durch ein Verfahren der eingangs genannten Art mit den Merkmalen des Anspruchs 1 gelöst.

Durch den Vergleich der tatsächlichen mit einer vorgegebenen Lage direkt im Bestückautomaten nach dem Bestückprozeß werden keine separaten Maschinen zur visuellen Kontrolle mehr benötigt. Der Bestückprozeß wird daher nicht unterbrochen und es sind beispielsweise auch keine separaten Programme für die separate Maschine und den Bestückautomaten notwendig. Durch die vorgegebene Auswahl der zu überprüfenden Bauelemente läßt sich ein Zeitvorteil gegenüber der Überprüfung jedes Bauelementes erzielen.

Ein zusätzlicher Vorteil ist darin zu sehen, daß eine fehlerhafte Lage bereits frühzeitig erkannt wird und somit das fehlerhafte Substrat aussortiert wird, ohne daß noch weitere kostenintensive Bestückprozesse oder auch andere Prozesse (Löten) vorgenommen werden.

Gegebenenfalls läßt sich bei einer frühzeitigen Erkennung der fehlerhaften Lage auch noch eine - beispielsweise manuelle - Lagekorrektur durchführen bzw. der fehlerhafte Bestückvorgang wiederholen.

In einer vorteilhaften Ausgestaltung nach Anspruch 2 wird als Sensor eine Kamera mit nachgeschalteter Bildauswerteeinheit benutzt. Solche Sensoren sowie die Verfahren zur Bildanalyse sind technisch ausgereift und bekannt und erlauben auf einfache Weise die Lageerkennung.

Bevorzugt eingesetzt wird das Verfahren gemäß Anspruch 3 bei der Bestückung von mehreren Bauelementen übereinander. Unter Bauelementen werden hierbei beispielsweise auch Kühlbleche verstanden, die im Bestückautomaten über elektronische Bauelemente bestückt werden. Auch größere Bauelemente werden teilweise zur Platzersparnis über bereits bestückte kleinere Bauelemente bestückt. Durch das erfindungsgemäße Verfahren kann die Lage der unten liegenden Bauelemente vor dem Bestükken der darüber liegenden Bauelemente bestimmt werden, wodurch aufwendige Röntgenuntersuchungen entfallen.

In vorteilhafter Weise läßt sich der Sensor gemäß Anspruch 4 zusammen mit dem Bestückkopf verfahren, wodurch jedes auf dem Substrat bestückte Bauelement in das Gesichtsfeld des Sensors kommt. Dadurch wird eine zusätzliche aufwendige Konstruktion eines Sensors vermieden.

In einer bevorzugten Ausgestaltung des Verfahrens gemäß Anspruch 5 wird der Sensor auch zur Bestimmung der Lage des Substrats im Bestückautomaten verwendet, wodurch für diese beiden Prozesse kostengünstig nur ein Sensor benötigt wird.

Für eine Zeitersparnis ist es vorteilhaft, die Position des Substrats im Bestückautomaten nur einmal vor dem Bestückvorgang mit den Bauelementen zu bestimmen gemäß Anspruch 6.

Das Verfahren wird bevorzugt zur Optimierung der Lagegenauigkeit des Bestückautomaten gemäß Anspruch 7 verwendet. Mit bekannten Optimierungsalgorithmen läßt sich so die Lagegenauigkeit im Bestückautomaten von Bauelement zu Bauelement verbessern.

Anhand des in den Figuren der Zeichnung dargestellten Ausführungsbeispiels wird die Erfindung näher erläutert.

Dabei zeigen
Figur 1 eine schematische Seitenansicht eines Bestückautomaten,
Figur 2 einen schematischen Schnitt durch ein mit einem Bauelement bestückten Substrat und
Figur 3 einen schematischen Schnitt durch ein Substrat mit zwei übereinander bestückten Bauelementen.

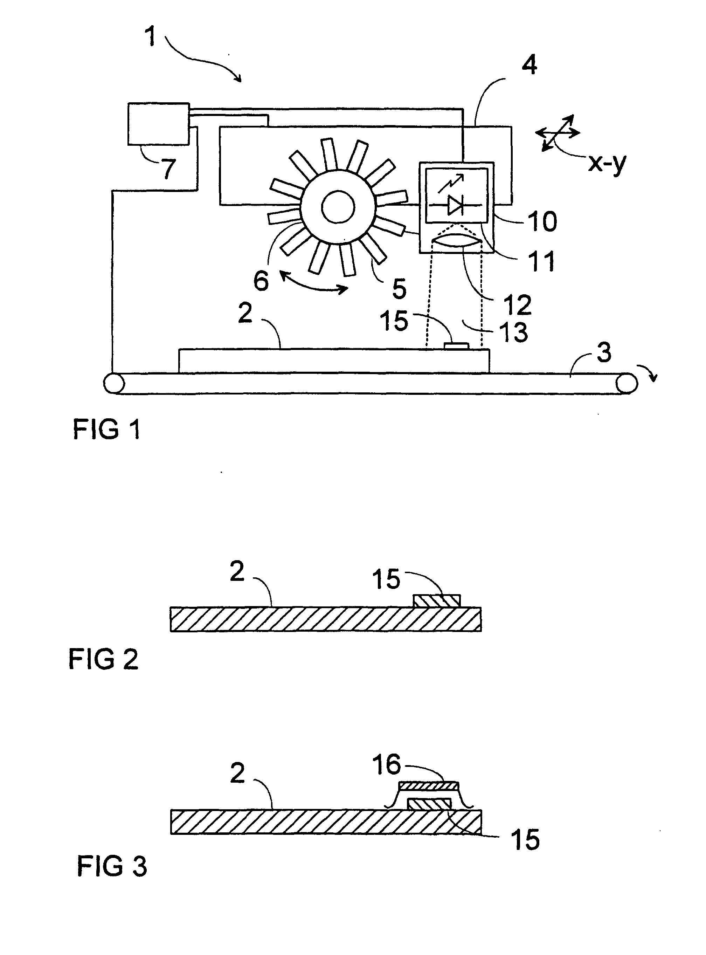

Mithilfe eines in Figur 1 dargestellten Bestückautomaten 1 werden Bauelemente 15 mithilfe von Haltevorrichtung 5 (beispielsweise Saugpipetten) aus nicht dargestellten Zuführeinheiten entnommen und auf ein Substrat 2 in einer vorgegebenen Lage positioniert. Das Substrat 2 wird dabei mittels einer Transportvorrichtung 3 in den Bestückautomaten transportiert. Die Haltevorrichtungen 5 sind über eine Befestigungsvorrichtung 6 an einem Bestückkopf 4 des Bestückautomaten 1 befestigt, der sich - von einer Steuereinrichtung 7 überwacht - in x-y-Richtung parallel zum Substrat 2 bewegt. Dadurch können alle Positionen auf dem Substrat 2 erreicht werden. Ein Sensor 10, beispielsweise eine Kamera aus einem optischen Detektor 11, einer optischen Abbildungseinrichtung 12 und einer nicht dargestellten Bildauswerteeinheit, die beispielsweise in der Steuereinrichtung angeordnet sein kann, erfaßt in seinem Gesichtsfeld 13 zumindest teilweise das bestückte Bauelement 15. Ist der Sensor 10 am Bestückkopf 4 befestigt, kann sein Gesichtsfeld 13 jeden Punkt des Substrates 2 im Bestückautomaten erreichen. Solche Sensoren 10 werden beispielsweise auch zur Lagebestimmung der Substrate 2 im Bestückautomaten 1 benutzt. Die bestimmte Lage der Substrate 2 wird dann während des Bestückprozesses bereits zur genauen Positionierung der Bauelemente 15 auf dem Substrat 2 verwendet.

Mit Hilfe dieses Sensors 10 wird die Lage von bestückten Bauelementen 15 ermittelt. Für die Überprüfung, ob sich das Bauelement überhaupt in der vorgegebenen Lage befindet und nicht etwa gar nicht vorhanden ist, eignet sich als Sensor 10 auch ein einfacher Höhensensor, beispielsweise ein handelsüblicher Triangulationssensor.

Welche Bauelemente 15 im einzelnen auf ihre Lage überprüft werden sollen, wurde in der Steuereinrichtung 7 vor Ablauf des Bestückprozesses zusammen mit den vorgegebener Lage abgespeichert. Die Bildauswerteeinheit vergleicht die vorgegebene Lage mit der tatsächlichen Lage und das Ergebnis wird wie folgt weiterverwendet. Bei positivem Ergebnis wird der Bestückprozeß fortgesetzt, bei einem negativem Vergleich wird eine Fehlermeldung ausgegeben. Die Fehlermeldung kann dann beispielsweise dazu führen, daß das fehlerhaft bestückte Substrat frühzeitig als solches erkannt und aus dem weiteren Prozeß entfernt wird. Kostenintensive weitere Prozeßschritte werden so gespart.

Besonders vorteilhaft wird das Verfahren angewandt, wenn wie in den Figuren 2 und 3 schematisch im Schnitt dargestellt ist, über ein bereits bestücktes Bauelement 15 ein weiteres Bauelement 16 (beispielsweise ein größeres Bauelement oder ein Kühlblech) bestückt wird. Durch die Lageerkennung im Bestückautomaten 1 ist es möglich, vor dem Bestücken des weiteren Bauelementes 16 eine Lageerkennung des unteren Bauelementes 15 durchzuführen, was ansonsten nur noch mit aufwendigen Verfahren, beispielsweise Röntgenverfahren möglich wäre.

Die Lageerkennung der bestückten Bauelemente 15 im Bestückautomaten 1 ist auch verwendbar, um während des Bestückprozesses die Lagegenauigkeit des Bestückautomaten 1 zu erhöhen. Stellt die Steuereinheit 7 beispielsweise regelmäßig Abweichungen zwischen vorgegebener und tatsächlicher Lage der Bauelemente 15 fest, wird mit an sich bekannten Verfahren der Bestückprozeß so lange angepaßt, bis vorgegebene und tatsächliche Lage besser übereinstimmen.

Durch das Verfahren wird somit eine frühzeitige Lageerkennung bestückter Bauelemente 15 ermöglicht.

## Patentansprüche

1. Verfahren zur Lageerkennung von in einem Bestückautomaten (1) auf ein Substrat (2) bestückten Bauelementen (15), bei dem
eine vorgegebene Lage der Bauelemente (15) vor dem Bestücken in einer Steuereinrichtung (7) des Bestückautomaten (1) abgespeichert wird,
eine Auswahl der Bauelemente (15), die nachkontrolliert wird, in der Steuereinrichtung (7) abgespeichert wird,
mit Hilfe eines Sensors (10) im Bestückautomaten (1) die tatsächliche Lage der Auswahl der Bauelemente (15) auf dem Substrat (2) nach dem Bestücken ermittelt wird,
die tatsächliche Lage mit der vorgegebenen Lage verglichen wird und
bei einer in einem vorgegebenen Rahmen liegenden Übereinstimmung zwischen vorgegebener und tatsächlicher Lage der Bestückprozeß für das Substrat (2) fortgesetzt wird und ansonsten eine Fehlermeldungs ausgegeben wird.

2. Verfahren zur Lageerkennung von in einem Bestückautomaten (1) auf ein Substrat (2) bestückten Bauelementen (15) nach Anspruch 1,
**dadurch gekennzeichnet,**
**daß** als Sensor (10) eine Kamera mit nachgeschalteter Bildauswerteeinheit benutzt wird.

3. Verfahren zur Lageerkennung von in einem Bestückautomaten (1) auf ein Substrat (2) bestückten Bauelementen (15) nach einem der Ansprüche 1 oder 2,
**dadurch gekennzeichnet,**
**daß** die Lageerkennung vor dem Bestücken eines weiteren Bauelementes (16) über das bereits bestückte Bauelement (15) erfolgt.

4. Verfahren zur Lageerkennung von in einem Bestückautomaten (1) auf ein Substrat (2) bestückten Bauelementen (15) nach einem der Ansprüche 1, 2 oder 3,
**dadurch gekennzeichnet,**
**daß** der Sensor (10) an einem Bestückkopf (4) des Bestückautomaten (1) befestigt ist und daher zusammen mit dem Bestückkopf (4) verfahren wird.

5. Verfahren zur Lageerkennung von in einem Bestückautomaten (1) auf ein Substrat (2) bestückten Bauelementen (15) nach einem der Ansprüche 1 bis 4,
**dadurch gekennzeichnet,**
**daß** der Sensor (10) auch zur Bestimmung der Lage des Substrats (2) im Bestückautomaten (1) verwendet wird.

6. Verfahren zur Lageerkennung von in einem Bestückautomaten (1) auf ein Substrat (2) bestückten Bauelementen (15) nach einem der Ansprüche 1 bis 5,
**dadurch gekennzeichnet,**
**daß** die Lage des Substrats (2) im Bestückautomaten nur einmal vor dem Bestücken bestimmt wird.

7. Verwendung des Verfahrens nach einem der Ansprüche 1 bis 6 um in einem Bestückautomaten die Lagegenauigkeit des Bestückprozesses anhand der Ergebnisse der Lageerkennung für folgende Bestückprozesse zu verbessern.

## Claims

1. Method for detecting the position of components (15) placed on a substrate (2) in a pick-and-place robot (1), in which
a predefined position of the components (15) is stored in a control device (7) of the pick-and-place robot (1) before they are placed,
a selection of the components (15), which is subsequently inspected, is stored in the control device (7),
with the aid of a sensor (10) in the pick-and-place robot (1), the actual position of the selection of components (15) on the substrate (2) is determined after they have been placed,
the actual position is compared with the predefined position and
if there is agreement within a predefined framework between the predefined and actual positions, the pick-and-place process for the substrate (2) is continued, and otherwise a fault message is output.

2. Method for detecting the position of components (15) placed on a substrate (2) in a pick-and-place robot (1) according to Claim 1, chararacterized in that the sensor (10) used is a camera with an image evaluation unit connected downstream.

3. Method for detecting the position of components (15) placed on a substrate (2) in a pick-and-place robot (1) according to either of Claims 1 and 2, **characterized in that** the position is detected, via the component (15) already placed, before a further component (16) is placed.

4. Method for detecting the position of components (15) placed on a substrate (2) in a pick-and-place robot (1) according to one of Claims 1, 2 or 3, **characterized in that** the sensor (10) is fixed to a pick-and-place head (4) of the pick-and-place robot (1) and is therefore moved together with the pick-and-place head (4).

5. Method for detecting the position of components (15) placed on a substrate (2) in a pick-and-place robot (1) according to one of Claims 1 to 4, **characterized in that** the sensor (10) is also used to determine the position of the substrate (2) in the pick-and-place robot (1).

6. Method for detecting the position of components (15) placed on a substrate (2) in a pick-and-place robot (1) according to Claims 1 to 5, **characterized in that** the position of the substrate (2) in the pick-and-place robot is determined only once, before the pick-and-place operation.

7. Use of the method according to one of Claims 1 to 6 in a pick-and-place robot to improve the positional accuracy of the pick-and-place process for subsequent pick-and-place processes by using the results of the position detection.

## Revendications

1. Procédé pour la reconnaissance de la position de composantes (15) montées sur un substrat (2) dans un automate d'équipement (1), dans lequel
une position prédéfinie des composantes (15) est mémorisée avant le montage dans un système de commande (7) de l'automate d'équipement (1),
un choix des composantes (15) qui sont soumises à un contrôle ultérieur est mémorisé dans le système de commande (7),
à l'aide d'un capteur (10) dans l'automate d'équipement (1), la position effective des composantes (15) choisies sur le substrat (2) est déterminée à l'issue du montage,
la position effective est comparée avec la position prédéfinie et
lors d'une concordance située dans un cadre prédéfini entre la position prédéfinie et la position effective, le processus de montage est poursuivi pour le substrat (2) et dans le cas contraire, un message d'erreur est émis.

2. Procédé pour la reconnaissance de la position de composantes (15) montées sur un substrat (2) dans un automate d'équipement (1) selon la revendication 1,
**caractérisé en ce**
**qu'**on utilise en tant que capteur (10) une caméra munie d'une unité d'évaluation d'images montée en aval.

3. Procédé pour la reconnaissance de la position de composantes (15) montées sur un substrat (2) dans un automate d'équipement (1) selon l'une quelconque des revendications 1 ou 2,
**caractérisé en ce que**
la reconnaissance de la position a lieu avant le montage d'une composante (16) supplémentaire au-dessus de la composante (15) préalablement posée.

4. Procédé pour la reconnaissance de la position de composantes (15) montées sur un substrat (2) dans un automate d'équipement (1) selon l'une quelconque des revendications 1, 2 ou 3,
**caractérisé en ce que**
le capteur (10) est fixé sur une tête de montage (4) de l'automate d'équipement (1) et qu'il se déplace donc en même temps que la tête de montage (4).

5. Procédé pour la reconnaissance de la position de composantes (15) posées sur un substrat (2) dans un automate d'équipement (1) selon l'une quelconque des revendications 1 à 4,
**caractérisé en ce que**
le capteur (10) est également utilisé pour déterminer la position du substrat (2) dans l'automate d'équipement (1).

6. Procédé pour la reconnaissance de la position de composantes (15) montées sur un substrat (2) dans un automate d'équipement (1) selon l'une quelconque des revendications 1 à 5,
**caractérisé en ce que**
la position du substrat (2) dans l'automate d'équipement (1) est déterminée seulement une seule fois avant le montage.

7. Utilisation du procédé selon l'une quelconque des revendications 1 à 6, pour améliorer la précision de position du processus de montage dans automate d'équipement, à l'aide des résultats de la reconnaissance de position pour les processus de montage suivants.
